# EUROPEAN PATENT APPLICATION

(11) **EP 2 621 251 A1**
(43) Date of publication of application: **31.07.2013**
(21) Application number: 13152817.6
(22) Date of filing: 28.01.2013
(51) Int. Cl.: H05K 1/02, H05K 1/16, H05K 3/02, H01T 1/00, H01C 7/12

(54) **Current carrying structures having enhanced electrostatic discharge protection and methods of manufacture**

(30) Priority: 30.01.2012 US 201213361504
(71) Applicant: Sony Mobile Communications AB, 221 88 Lund (SE)
(72) Inventor: Lövskog, Tomas, 244 41 Kävlinge (SE); Strandh, Jonny, 243 94 Hörby (SE)
(74) Representative: Valea AB

(57) **Abstract**

A method is provided for forming a current carrying structure (100) with improved electrostatic discharge protection. The current carrying structure includes a conductive material layer (106) and a voltage switchable dielectric layer (104) adapted to switch between insulative and conductive at a predetermined voltage between the ground plane and the conductive material. An aperture (108) is formed through the voltage switchable dielectric layer, and conductive material (110) is deposited in the aperture to form a conductive pathway between the voltage switchable dielectric layer and another layer. A spark gap (114) is created between the conductive material (110) of the aperture and a ground portion (118) using a laser to remove a portion of the conductive material layer (106) from an area surrounding the aperture without substantially modifying physical properties of the underlying switchable dielectric layer.

## Description

### TECHNICAL FIELD OF THE INVENTION

The present invention relates to current carrying structures used in electronic devices and more particularly to methods and systems for providing enhanced electrostatic discharge protection in current carrying structures.

### DESCRIPTION OF THE RELATED ART

Current-carrying structures are generally fabricated by subjecting a substrate to a series of manufacturing steps. Examples of such current-carrying structures include printed circuit boards, printed wiring boards, backplanes, and other micro-electronic types of circuitry. The substrate is typically a rigid, insulative material such as epoxy-impregnated glass fiber laminate. A conductive material, such as copper, is patterned to define conductors, including ground and power planes.

Current-carrying devices may be manufactured by layering a conductive material over a substrate. A mask layer may be deposited on the conductive layer, exposed, and developed. The resulting pattern exposes select regions where conductive material is to be removed from the substrate. The conductive layer may then be removed from the select regions by etching. The mask layer is subsequently removed, leaving a patterned layer of the conductive material on the surface of the substrate. In other manufacturing processes, an electroless process may be used to deposit conductive lines and pads on a substrate. A plating solution may then be applied to facilitate adherence of the conductive material to the substrate on selected portions of the substrate to form patterns of conductive lines and pads.

To maximize available circuitry in a limited footprint, substrate devices sometimes employ multiple substrates, or include circuitry on both surfaces of a single substrate. In either case, it may be desirable to interconnected the multiple surfaces to establish electrical communication between components on different substrate surfaces. Sleeves or vias are often provided with conductive layering extend through the substrate to connect the multiple surfaces. In multi-substrate devices, such vias may extend through at least one substrate to interconnect one surface of that substrate to a surface of another substrate. In this way, an electrical link is established between electrical components and circuitry on two surfaces of the same substrate, or on surfaces of different substrates.

In some processes, via surfaces are plated by first depositing a seed layer of a conductive material followed by an electrolytic process. In other processes, adhesives are used to attach conductive material to via surfaces. In such devices, the bond between the vias and conductive material may be mechanical in nature.

Certain materials, referred to below as voltage switchable dielectric materials, have been used to provide over voltage protection. Because of their electrical resistance properties, these materials may be used in devices such as circuit boards to dissipate voltage surges from, for example, lightning, static discharge, or power surges.

### SUMMARY

Accordingly, there is a need in the art, particularly in the field of mobile devices, for improved electrostatic discharge protection. In particular, there is a need in the art for a process of making current carrying structures having improved electrostatic discharge protection. Current manufacturing processes, when combined with existing materials, do not meet this need. The present invention provides for the production of current carrying structures having spark gap protection that is triggered at much lower voltages, and thereby provides much greater electrostatic discharge protection, than is possible using existing methodologies.

Accordingly, there is provided a method of forming a current carrying structure from a multilayered structure comprising a conductive material layer and a voltage switchable dielectric layer adjacent the conductive material layer and adapted to switch between insulative and conductive at a predetermined voltage. The method includes creating an aperture passing through the voltage switchable dielectric layer; depositing conductive material in the aperture to form a conductive pathway between the voltage switchable dielectric layer and another layer of the multilayered structure; removing portions of the conductive material layer to create a conductive material pattern; and using a laser to form a spark gap by removing a portion of the conductive material layer from an area surrounding the aperture without substantially modifying physical properties of the switchable dielectric layer; wherein the voltage switchable dielectric layer is adapted to carry a current across the spark gap when the voltage across a portion of the conduction material layer adjacent the spark gap exceeds the predetermined voltage.

According to one aspect of the invention, the method further includes chemically treating the portion of the conductive material layer surrounding the aperture to decrease the reflectivity of the conductive material. The chemical treatment may be, for example, a black oxide treatment.

According to one aspect of the invention, at least part of the conductive material pattern may be formed by chemical etching.

According to one aspect of the invention, the conductive material layer may include at least one of: Cu, Au, Ag, Sn, or Al.

According to one aspect of the invention, the laser may be, for example, a CO2 laser or an ultraviolet laser. The pulse length of the laser may range from approximately 6 microseconds to approximately 18 microseconds.

According to one aspect of the invention, the predetermined voltage of the voltage switchable dielectric layer increases as the size of the spark gap increases.

According to one aspect of the invention, the predetermined voltage is a function of the distance between the aperture and the spark gap and the circumference of the spark gap surrounding the aperture.

According to one aspect of the invention, the aperture may be generally circular and the surrounding spark gap may be generally non-circular. For example, the surrounding spark gap may be generally star-shaped.

According to one aspect of the invention, the spark gap may be dimensioned to create a predetermined voltage of less than about 40V.

According to one aspect of the invention, there is provided a portable electronic device comprising a current carrying structure formed using the method of claim 1.

According to one aspect of the invention, there is provided a multilayered current carrying structure including: a conductive material layer having a conductive material pattern; a voltage switchable dielectric layer adjacent the conductive material layer, wherein the voltage switchable dielectric material is adapted to switch between insulative and conductive at a predetermined voltage; an aperture passing through the voltage switchable dielectric layer; conductive material in the aperture forming a conductive pathway between the voltage switchable dielectric layer and another layer of the multilayered current carrying structure; a laser formed spark gap in the conductive material between the aperture and the conductive material pattern. The predetermined voltage may be defined by the dimension of the spark gap and the dimension of the spark gap may define a predetermined voltage of less than about 40V.

According to one aspect of the invention, the current carrying structure includes a second non-laser formed conductive material pattern in the conductive material layer, wherein the laser formed conductive material pattern and the non-laser formed conductive material pattern intersect.

According to one aspect of the invention, the conductive material layer comprises at least one of: Cu, Au, Ag, Sn, or Al.

According to one aspect of the invention the predetermined voltage of the voltage switchable dielectric layer may increase as the size of the spark gap increases.

According to one aspect of the invention, the predetermined voltage may be a function of the distance between the aperture and the laser formed conductive material pattern and the circumference of the laser formed conductive material pattern surrounding the aperture.

According to one aspect of the invention, the aperture is generally circular and the laser formed conductive material pattern is non-circular. For example, the surrounding conductive material may be generally star-shaped.

These and further features of the present invention will be apparent with reference to the following description and attached drawings. In the description and drawings, particular embodiments of the invention have been disclosed in detail as being indicative of some of the ways in which the principles of the invention may be employed, but it is understood that the invention is not limited correspondingly in scope. Rather, the invention includes all changes, modifications and equivalents coming within the spirit and terms of the claims appended hereto.

Features that are described and/or illustrated with respect to one embodiment may be used in the same way or in a similar way in one or more other embodiments and/or in combination with or instead of the features of the other embodiments.

It should be emphasized that the terms "comprises" and "comprising," when used in this specification, are taken to specify the presence of stated features, integers, steps or components but do not preclude the presence or addition of one or more other features, integers, steps, components or groups thereof.

### BRIEF DESCRIPTION OF THE DRAWINGS

FIG. 1 is a cross-sectional schematic diagram of a layered current carrying structure;

FIGS. 2A-C are exemplary spark gap patterns surround vias; and

FIG. 3 depicts an exemplary flow chart for manufacturing a current carrying structure.

### DETAILED DESCRIPTION OF EMBODIMENTS

Embodiments of the present invention will now be described with reference to the drawings, wherein like reference numerals are used to refer to like elements throughout. It will be understood that the figures are not necessarily to scale.

The present invention provides for improved electrostatic discharge ("ESD") protection for current-carrying structures, such as circuit boards, wiring boards, backplanes, and other micro-electronic types of circuitry. Recent advances in materials have yielded voltage switchable dielectric materials that may be used in current carrying structures, such as between a ground and a conductive material layer. The voltage switchable dielectric layer may be adapted to switch between insulative and conductive at a predetermined voltage between ground and the conductive material. The present invention utilizes the advantages of such materials to improve ESD protection by creating spark gaps in the conductive material layer. Unlike the prior art, a laser etching technique is used to remove part of the conductive material layer to form a conductive pattern surrounding a via, and a spark gap therebetween.

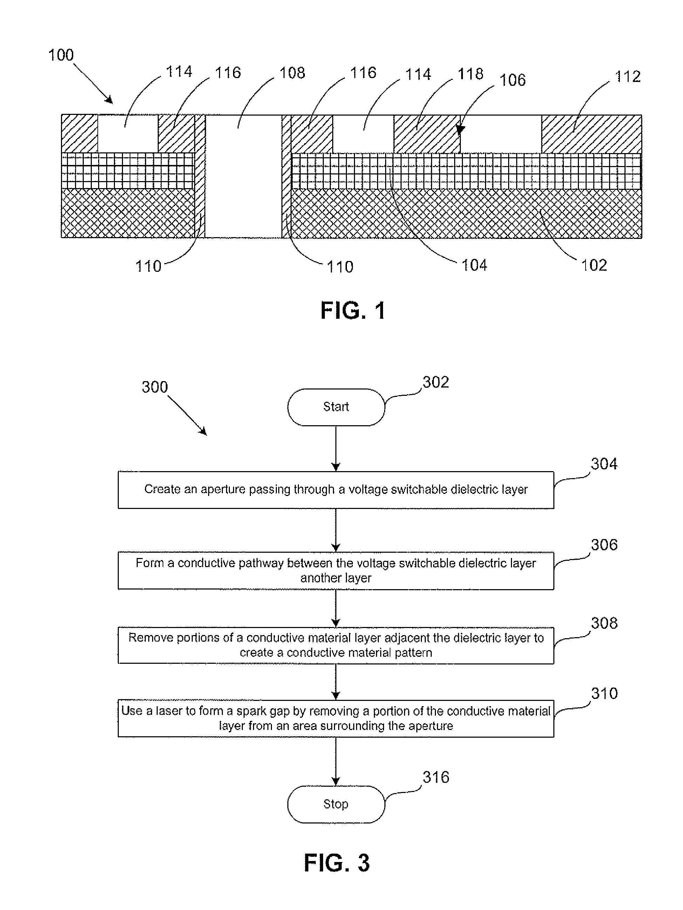

With reference to FIG. 1, an exemplary cross-sectional schematic diagram of a current carrying structure is provided. The current carrying structure 100 may be any current carrying structure, such as a circuit board, wiring board, backplane, other micro-electronic types of circuitry, or the like. The current carrying structure 100 includes a substrate 102, a voltage switchable dielectric material layer 104 and a conductive material layer 106.

The conductive material layer 106 may be any type of conductive material commonly used in the manufacture of current carrying structures. For example, the conductive material may be, for example, made from one or more of Cu, Au, Ag, Sn, or Al. In addition, the substrate 102 may be any type of substrate, such as a glass fiber substrate, used in the manufacture of multilayer current carrying structures.

The voltage switchable dielectric material layer 104 resides between the substrate 102 and the conductive material layer 106. The voltage switchable dielectric material in the voltage switchable dielectric material layer 104 may be any material that is generally non-conductive until a voltage is applied that exceeds a characteristic threshold voltage value. Above the characteristic threshold voltage value the material becomes conductive. Therefore, a voltage switchable dielectric material 104 is switchable between a non-conductive state and a conductive state. Examples of voltage switchable dielectric materials are provided in references such as U.S. Pat. No. 4,977,357, U.S. Pat. No. 5,068,634, U.S. Pat. No. 5,099,380, U.S. Pat. No. 5,142,263, U.S. Pat. No. 5,189,387, U.S. Pat. No. 5,248,517, U.S. Pat. No. 5,807,509, U.S. Pat. App. No. 2009/0044970, WO 96/02924, and WO 97/26665, all of which are incorporated by reference in their entireties herein. The present invention is intended to encompass modifications, derivatives, and changes to any of the references listed above or below.

In order connect the conductive material layer 106 to other layers of the multilayer structure, at least one aperture, such as via 108 may be created. Any number of vias 108 may be drilled, etched, or otherwise formed into the substrate. The via 108 passes through the voltage switchable dielectric material layer 104 to another layer of the structure. The via 108 may interconnect current-carrying elements, including electrical components or circuitry. Accordingly, conductive material 110 may be deposited in the via 108 to create a conductive pathway between the conductive material layer 106 and another layer. In addition, surrounding the via 108 may be a via pad 116, which also may be formed of conductive material, such as the material of the conductive material layer 106. Thus, the conductive material 110 may create a conductive pathway between the via pad 116 and another layer of the multilayer structure. The via pad 116 and conductive material 110 are normally isolated from ground portion 118.

Portions of the conductive material layer 106 may be removed to form a conductive material pattern 112, which may be in the same layer as the ground portion or in another layer of the multilayered structure. For example, chemical etching may be used to form the conductive material pattern 112. In addition, a portion of the conductive material layer 106 may be removed from an area surrounding the via 108 to form a spark gap 114. It will also be understood by those of ordinary skill in the art that the conductive material layer 106 may also include a ground portion 118 that forms a pathway to ground, which is isolated from via pad 116 and conductive material 110 when the voltage switchable dielectric layer 106 is non-conductive. In addition, it will further be understood by those of ordinary skill in the art that the specific layered configuration of the multilayer structure is not limiting. There are many configurations of layers, conductive and insulative, as well as combinations of patterns, that are contemplated by the spark gap technology of the present invention. The spark gaps 114 described herein may be utilized in a variety of configurations of multilayer current carrying structures having vias, such as vias 108.

In one embodiment, a laser is used to remove the conductive material surrounding the via 108. One advantage of using a laser as opposed to typical etching techniques is that the laser may enable the creation of more precise patterns having straighter lines and edges. The laser may be any suitable laser, such as a CO₂ laser or an ultraviolet laser, for removing the conductive material layer 106. For example, in the instance where the conductive material layer 106 is Cu, a CO₂ laser operating at 5600A, 7J, 100Hz modulation may be used. In addition, the pulse length of the laser may range from approximately 6 microseconds to approximately 18 microseconds. In one specific example, the pulse length of the laser is 12 microseconds. One of skill in the art will recognize that the specific calibration of the laser will depend on the type of material and thickness of the conductive material layer 106. For example, the number of pulses fired will vary, but may be adapted so as to cut through the conductive material layer 106, but not harm the underlying voltage switchable dielectric layer 104.

It should be understood by those skilled in the art that laser etching may be used to form the spark gap 114 and the conductive material pattern 112. In addition, part of the conductive material pattern 112 may be formed using non-laser techniques, such as chemical etching, in addition to using laser etching to create a spark gap 114.

In addition, to facilitate laser removal of conductive material, the conductive material may be chemically treated prior to laser treatment to decrease the reflectivity of the conductive material. For example, a black oxide treatment or the like may be utilized.

Accordingly, because the material in the voltage switchable dielectric material layer 106 is adapted to switch from non-conductive to conductive when a voltage is applied exceeding a predetermined value, applying a voltage exceeding the predetermined voltage will cause the voltage switchable dielectric material layer 106 to carry a current across the spark gap 114 between the via pad 116 and conduction material 110 and the ground portion 118, thereby providing electrostatic discharge protection for any circuitry and devices on the current carrying structure 100.

In addition, the material of the voltage switchable dielectric layer 104 may be adapted such that the predetermined voltage increases as the size of the spark gap 114 increases. In addition, the predetermined voltage may be a function of the circumference of the conductive material surrounding the aperture 108. Also, the predetermined voltage may be a function of the distance between the aperture and the spark gap and the circumference of the spark gap surrounding the aperture. In one embodiment, the predetermined voltage is less than about 40V. Through the use of laser etching, the predetermined voltage may be lowered further to less than 30V or less than 25V using known voltage switching dielectric materials.

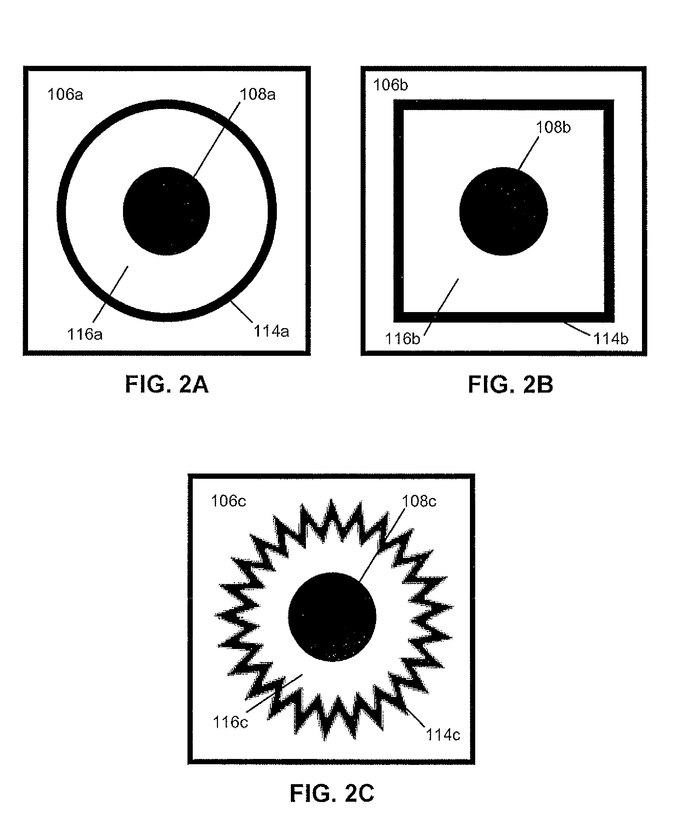

Referring next to Figs. 2A-C, exemplary spark gap patterns surrounding vias are provided. Fig. 2A depicts a typical round via 108a, surrounded by a via pad 116a and a spark gap 114a. Figs. 2B-C illustrate exemplary spark gap patterns in which the via 108b-c is generally circular, surrounded by a via pad 116b-c, but the spark gap 114 is generally non-circular. Such embodiments may offer a lower predetermined voltage than a circular spark gap, such as that shown in Fig. 2A. For example, the spark gap 114b in Fig. 2B is generally rectangular, and may be generally square. In addition, the spark gap 114c in Fig. 2C is generally star-shaped. By modifying the shape, position, and size of the spark gap 114, different predetermined voltages of the voltage switchable dielectric material can be achieved. It will be understood by those skilled in the art that other shapes and configurations are possible, particular with the precision of laser etching. The configurations illustrated in Figs. 2A-C, as well as any other shapes and configurations, may be utilized in conjunction with the current carrying structure 100 illustrated in Fig. 1.

The current carrying structures of the present invention, such as the current carrying structure 100, may be suitably used in a portable electronic device. The portable electronic device may be any type of portable electronic device. Such devices include but are not limited to mobile phones, digital cameras, digital video cameras, mobile PDAs, tablets, other mobile radio communication devices, gaming devices, portable media players, or the like. In the most common scenario, the exemplary portable electronic device is a mobile phone. It will also be appreciated that the "portable electronic device" of present invention is not limited to "portable" devices and instead is directed to devices capable of installing applications. According, the portable electronic device may be embodied in computers, including desktops, laptops, tablets and the like, as well as in television and home theater settings. It should be understood, however, that the "portable electronic device" need not be "portable" and may in fact be incorporated into other non-portable devices or structures.

Referring next to Fig. 4, an exemplary methodology or process 300 for producing a current carrying structure is illustrated. Flow begins at process block 302 where an aperture passing through a voltage switchable dielectric layer is created in a current carrying structure having a voltage switchable dielectric layer and a conductive material layer and another layer. Flow continues to process block 304, wherein a conductive pathway is formed between the voltage switchable dielectric layer and another layer, such as by depositing conductive material in the aperture. Progression then continues to process block 306 wherein portions of a conductive material layer are removed to create a conductive material pattern. Flow then continues to process block 308 wherein a laser is used to form a spark gap by removing a portions of a conductive material layer from an area surrounding the aperture. Flow then continues to termination block 310. It will be understood by one of ordinary skill in the art that the conductive material pattern and the spark gap may be in the same conductive material layer or in different conductive material layers. It also will be understood by one of ordinary skill in the art that the order of the events of the methodology of Fig. 4 is not limiting, and that the sequence may be modified.

Specific embodiments of an invention are disclosed herein. One of ordinary skill in the art will readily recognize that the invention may have other applications in other environments. In fact, many embodiments and implementations are possible. The following claims are in no way intended to limit the scope of the present invention to the specific embodiments described above.

Although the invention has been shown and described with respect to a certain preferred embodiment or embodiments, it is obvious that equivalent alterations and modifications will occur to others skilled in the art upon the reading and understanding of this specification and the annexed drawings. In particular regard to the various functions performed by the above described elements (components, assemblies, devices, compositions, etc.), the terms (including a reference to a "means") used to describe such elements are intended to correspond, unless otherwise indicated, to any element which performs the specified function of the described element (i.e., that is functionally equivalent), even though not structurally equivalent to the disclosed structure which performs the function in the herein illustrated exemplary embodiment or embodiments of the invention. In addition, while a particular feature of the invention may have been described above with respect to only one or more of several illustrated embodiments, such feature may be combined with one or more other features of the other embodiments, as may be desired and advantageous for any given or particular application. The present invention includes all such equivalents and modifications, and is limited only by the scope of the following claims.

## Claims

1. A method of forming a current carrying structure from a multilayered structure comprising a conductive material layer and a voltage switchable dielectric layer adjacent the conductive material layer and adapted to switch between insulative and conductive at a predetermined voltage, the method comprising:
creating an aperture passing through the voltage switchable dielectric layer;
depositing conductive material in the aperture to form a conductive pathway between the voltage switchable dielectric layer and another layer of the multilayered structure;
removing portions of the conductive material layer to create a conductive material pattern; and
using a laser to form a spark gap by removing a portion of the conductive material layer from an area surrounding the aperture without substantially modifying physical properties of the switchable dielectric layer;
wherein the voltage switchable dielectric layer is adapted to carry a current across the spark gap when the voltage across a portion of the conduction material layer adjacent the spark gap exceeds the predetermined voltage.

2. The method of claim 1 further comprising chemically treating the portion of the conductive material layer surrounding the aperture to decrease the reflectivity of the conductive material.

3. The method of claim 2 wherein the chemical treatment is a black oxide treatment.

4. The method of any one of the previous claims wherein at least part of the conductive material pattern is formed by chemical etching.

5. The method of any one of the previous claims wherein the laser comprises one of: a CO₂ laser or an ultraviolet laser.

6. The method of claim 5 wherein the pulse length of the laser ranges from approximately 6 microseconds to approximately 18 microseconds.

7. The method of any one of the previous claims wherein the aperture is generally circular and the surrounding spark gap is generally non-circular.

8. The method of any one of the previous claims wherein the surrounding spark gap is generally star-shaped.

9. The method of any one of the previous claims wherein the predetermined voltage is a function of the distance between the aperture and the spark gap and the circumference of the spark gap surrounding the aperture,

10. A portable electronic device comprising a current carrying structure formed using the method of any one of the previous claims.

11. A multilayered current carrying structure comprising:
a conductive material layer having a conductive material pattern;
a voltage switchable dielectric layer adjacent the conductive material layer, wherein the voltage switchable dielectric material is adapted to switch between insulative and conductive at a predetermined voltage;
an aperture passing through the voltage switchable dielectric layer;
conductive material in the aperture forming a conductive pathway between the voltage switchable dielectric layer and another layer of the multilayered current carrying structure;
a laser formed spark gap in the conductive material between the aperture and the conductive material pattern;
wherein the predetermined voltage is defined by the dimension of the spark gap; and
wherein the dimension of the spark gap defines a predetermined voltage of less than about 40V.

12. The current carrying structure of claim 11 further comprising a second non-laser formed conductive material pattern in the conductive material layer, wherein the laser formed conductive material pattern and the non-laser formed conductive material pattern intersect.

13. The current carrying structure of any one of claims 11-12 wherein the aperture is generally circular and the laser formed conductive material pattern is generally non-circular.

14. The current carrying structure of claim 13 wherein the laser formed conductive material pattern is generally star-shaped.

15. The current carrying structure of any one of claims 11-14 wherein the predetermined voltage is a function of the distance between the aperture and the laser formed conductive material pattern and the circumference of the laser formed conductive material pattern surrounding the aperture.
